(19) Europäisches Patentamt
European Patent Office
Office européen des brevets

(11) **EP 4 086 040 B1**

(12) **EUROPEAN PATENT SPECIFICATION**

(45) Date of publication and mention
of the grant of the patent:
**18.06.2025 Bulletin 2025/25**

(21) Application number: **22170775.5**

(22) Date of filing: **29.04.2022**

(51) International Patent Classification (IPC):
**B24B 37/20** (2012.01)    **H01L 21/306** (2006.01)
**B24B 37/013** (2012.01)

(52) Cooperative Patent Classification (CPC):
**B24B 37/205; B24B 37/013;** H01L 21/02024

(54) **POLISHING PAD, MANUFACTURING METHOD THEREOF, METHOD FOR MANUFACTURING SEMICONDUCTOR DEVICE USING SAME**

POLIERKISSEN, HERSTELLUNGSVERFAHREN DAFÜR, VERFAHREN ZUM HERSTELLEN EINER HALBLEITERANORDNUNG UNTER VERWENDUNG DESSELBEN

TAMPON DE POLISSAGE, SON PROCÉDÉ DE FABRICATION, PROCÉDÉ DE FABRICATION DE DISPOSITIF SEMI-CONDUCTEUR L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.05.2021 KR 20210057725**

(43) Date of publication of application:
**09.11.2022 Bulletin 2022/45**

(73) Proprietor: **SK enpulse Co., Ltd.**
**Pyeongtaek-si, Gyeonggi-do 17784 (KR)**

(72) Inventors:
• **YUN, Sung Hoon**
**03142 Seoul (KR)**
• **AHN, Jae In**
**16338 Suwon-si, Gyeonggi-do (KR)**
• **JOENG, Eun Sun**
**16338 Suwon-si, Gyeonggi-do (KR)**
• **SEO, Jang Won**
**03142 Seoul (KR)**

(74) Representative: **BCKIP Part mbB**
**MK1**
**Landsbergerstraße 98, 3.Stock**
**80339 München (DE)**

(56) References cited:
**WO-A1-2019/031788      JP-A- 2008 226 911**
**KR-B1- 102 237 321**

Description

CROSS-REFERENCE TO RELATED APPLICATION(S)

This application claims priority to Korean Patent Application No. 10-2021-0057725, filed on May 04, 2021.

Technical Field

The present disclosure relates to a polishing pad used in a chemical mechanical planarization (CMP) process, a manufacturing method thereof, and a method for manufacturing a semiconductor device using the same.

Description of the Related Art

The chemical mechanical planarization (CMP) process during the semiconductor manufacturing process is a process of mechanically planarizing the concave-convex part of the wafer surface by moving the platen and the head relative to each other while chemically reacting the surface of the wafer by supplying a slurry in a state where a wafer is attached to a head and brought into contact with the surface of a polishing pad formed on a platen.

The chemical mechanical planarization process is one which uses a polishing pad. In addition to semiconductor manufacturing processes, it can be used in various ways for planarization processing of materials requiring high surface flatness, such as memory disks, magnetic disks, optical materials such as optical lenses and reflective mirrors, glass plates, and metals.

With the miniaturization of semiconductor circuits, the importance of the CMP process is further highlighted. The polishing pad plays an important role in realizing CMP performance as one of the essential raw and subsidiary materials for the CMP process among the semiconductor manufacturing processes.

Recently, various methods for detecting the thickness of the wafer and detecting the end point of the CMP process through this have been proposed.

For example, a method of coupling a window to a polishing pad in order to determine the flatness of the wafer surface in-situ and measuring the thickness of the wafer through a reflected beam generated by an interferometer of a laser through the window has been proposed. In the in-situ method, the window should maintain the incident light intensity constant, and the deviation of light transmittance before and after polishing should be small so that the error of end-point detection may be minimized.

However, in the in-situ method, the window of the polishing pad should have stable transmittance in order to minimize an error in endpoint detection performance. The surface roughness of the window, which is one of the important factors determining the transmittance, may be changed in the polishing process, and thus corresponds to a factor affecting the transmittance.

JP 2008 226911 A discloses polishing performance and optical end point detection of a polishing pad by having a surface roughness of the window region smaller than the surface roughness of the polishing surface. WO 2019/031788 A1 discloses methods of manufacturing polishing pads.

It is necessary to develop a polishing pad capable of minimizing the effect on transmittance according to the surface roughness by improving such a problem.

SUMMARY

An object of the present disclosure to provide a polishing pad, a manufacturing method of the polishing pad, and a method for manufacturing a semiconductor device using the same.

Another object of the present disclosure is to provide a polishing pad capable of preventing an endpoint detection error due to the window in the polishing pad by minimizing the effect on transmittance according to the surface roughness of a window in the polishing pad in the polishing process, and a method for manufacturing the same.

Another object of the present disclosure is to provide a polishing pad which maintains a surface roughness difference between the polishing layer and the window in the polishing pad within a predetermined range so that the fluidity and loading rate of the polishing slurry in the polishing process are implemented at similar levels, thereby enabling a problem of deterioration of polishing performance due to a surface difference between the polishing layer and the window to be prevented, and a method for manufacturing the same.

Another object of the present disclosure is to provide a method for manufacturing a semiconductor device to which a polishing pad is applied.

In order to achieve the above objects, a polishing pad according to the invention includes a polishing layer and a window for end-point detection, and the surface roughness (Ra) of the polishing layer and the window for end-point detection has a surface roughness rate of difference change (SRR) represented by the following Equation 1 of 1.9 to 2.2:

[Equation 1]

$$SRR = \frac{dRa1}{dRa2}$$

where,

dRa1 is a surface roughness difference between the polishing layer and the window before polishing, and dRa2 is a surface roughness difference between the polishing layer and the window measured after supplying a calcined ceria slurry as the polishing layer at 200 mL/min, maintaining a wafer load of 41.4 kPa (6.0 psi), polishing an oxide film at a speed of 150 rpm for 60 seconds, and polishing 100 wafer sheets under the above conditions.

A method for manufacturing a semiconductor device according to the invention has been defined in claim 11.

The present disclosure can prevent an error in detecting the end point due to the window in the polishing pad by minimizing the effect on transmittance according to the surface roughness of the window in the polishing pad in the polishing process, and allows the fluidity and loading rate of the polishing slurry in the polishing process to be implemented at similar levels by maintaining the surface roughness difference between the polishing layer and the window in the polishing pad within the predetermined range, thereby enabling the problem of deterioration of polishing performance due to the surface difference between the polishing layer and the window to be prevented.

### BRIEF DESCRIPTION OF THE DRAWINGS

FIG. 1 is a schematic process diagram of a semiconductor device manufacturing process according to an embodiment of the present disclosure.

FIG. 2 is a conceptual diagram illustrating changes in surface roughness of a polishing layer and a window according to an embodiment of the present disclosure.

### DESCRIPTION OF SPECIFIC EMBODIMENTS

Hereinafter, embodiments of the present disclosure will be described in detail so that those with ordinary skill in the art to which the present disclosure pertains will be able to easily implement the present disclosure. However, the present disclosure may be embodied in various different forms within the scope of the appended claims.

Unless otherwise stated in the present disclosure, all percentages, parts, ratios, etc. are by weight.

In the present disclosure, if a prescribed part "includes" a prescribed element, this means that another element can be further included instead of excluding other elements unless any particularly opposite description exists.

In the present disclosure, "a plurality of" refers to more than one.

The polishing pad according to the invention includes a polishing layer and a window for end-point detection, and the surface roughness (Ra) of the polishing layer and the window for end-point detection has a surface roughness rate of difference change (SRR) represented by the following Equation 1 of 1.9 to 2.2:

[Equation 1]

$$SRR = \frac{dRa1}{dRa2}$$

where,

dRa1 is a surface roughness difference between the polishing layer and the window before polishing, and dRa2 is a surface roughness difference between the polishing layer and the window measured after supplying a calcined ceria slurry as the polishing layer at 200 mL/min, maintaining a wafer load of 6.0 psi (41.4 kPa), polishing an oxide film at a speed of 150 rpm for 60 seconds, and polishing 100 wafer sheets under the above conditions.

In general, a polishing pad not only mechanically rubs a semiconductor substrate, but also chemically polishes a polishing target film of a semiconductor wafer using a polishing slurry. The polishing target film of the semiconductor substrate polished by the mechanical and chemical action of the polishing pad and the slurry should be polished until it has a predetermined thickness. That is, it is necessary to detect a polishing end point at which polishing should be stopped, and for this, the thickness of the polishing target film to be polished is detected using light to detect the end point.

A polishing end-point detection device of general chemical mechanical polishing equipment is specifically comprised of a disk-shaped platen top plate having a through-hole in the periphery, an optical sensor unit inserted into the through-hole of the platen top plate, and a polishing pad that is positioned on the upper portion of the platen top plate to provide a polishing surface with a polishing target film of a semiconductor substrate and includes a window for end-point detection corresponding to the optical sensor unit.

The optical sensor unit may be configured to emit light of a light emitting unit provided at a position separate from the top plate, and to perform a role of transmitting light reflected from a polishing target film of a semiconductor substrate to a light receiving unit provided at a separate position.

The window for end-point detection included in the polishing pad should generally exhibit stable transmittance, and the transmittance of the window is affected by various factors such as composition, surface roughness, and thickness.

In particular, in the case of roughness, which can be changed in the polishing process, the surface roughness of the window in the polishing pad applied to the polishing process has a direct effect on transmittance.

This is due to conditioning for exhibiting a certain polishing performance in the polishing process, and the polishing layer of the polishing pad is cut by conditioning, and in this case, a change in the surface roughness of the window is also exhibited.

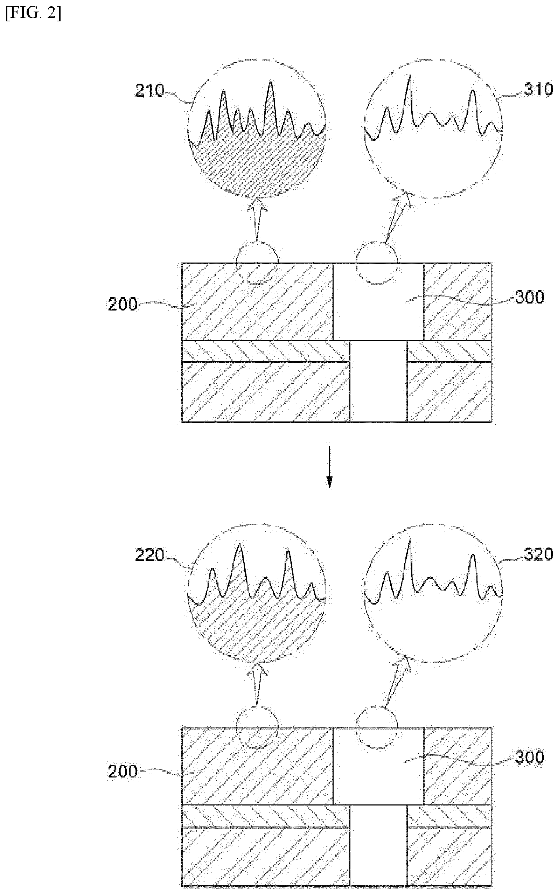

Specifically, as shown in FIG. 2, when the surface roughness 210 of the polishing surface and the surface roughness 310 of the window before the polishing process are compared with those after the polishing process, changes appear in the surface roughness 220 of the polishing surface and the surface roughness 320 of the window after the polishing process, which is not only changed by direct contact with the semiconductor substrate in the polishing process, but also changed by conditioning.

Accordingly, it is necessary to check whether or not the polishing target film of the semiconductor substrate is polished to a specific thickness during the polishing process, which is sensed by light transmitted through the window in the polishing pad.

When the surface roughness of the window is changed, the degree of absorption of light passing through the window is changed, and there may be a problem in that a change in end-point detection performance occurs depending on this change.

In addition, although the composition, wear rate, and physical properties of the polishing layer and the window are different from each other, the surface roughness of the polishing layer is directly related to the polishing performance of the polishing target film of the semiconductor substrate, and when there is a surface roughness difference between the polishing layer and the window within a predetermined range, the fluidity or loading rate of the polishing slurry is implemented at a similar level, and thus the effect influencing on polishing performance due to the surface difference is less.

Further, when the surface roughness deviation value between the polishing layer and the window satisfies a predetermined range after the polishing process is progressed, a change in the flow and loading performance of the polishing slurry in the polishing process is varied to an appropriate level, and thus exhibition of a certain polishing performance will be said to be possible.

Due to the characteristics described above, as shown in Equation 1 above, the polishing pad according to the present disclosure has derived optimal ranges for: a difference between the surface roughness of the polishing layer and the surface roughness of the window before polishing; and a difference between the surface roughness of the polishing layer and the surface roughness of the window after performing the polishing process.

Specifically, the surface roughness (Ra) of the polishing layer and the window for end-point detection has a surface roughness rate of difference change (SRR) represented by the following Equation 1 of 1.9 to 2.2:

[Equation 1]

$$SRR = \frac{dRa1}{dRa2}$$

where,

dRa1 is a surface roughness difference between the polishing layer and the window before polishing, and

dRa2 is a surface roughness difference between the polishing layer and the window measured after supplying a calcined ceria slurry as the polishing layer at 200 mL/min, maintaining a wafer load of 41.4 kPa (6.0 psi), polishing an oxide film at a speed of 150 rpm for 60 seconds, and polishing 100 wafer sheets under the above conditions.

The polishing layer and the window have a surface roughness difference (dRa1) before polishing of 6 to 7, preferably 6.5 to 6.9, and more preferably 6.7 to 6.9.

In the polishing layer and the window, surface roughness values of the polishing layer and the window are measured after supplying a calcined ceria slurry as the polishing layer at 200 mL/min, maintaining a wafer load of 6.0 psi (41.4 kPa), polishing an oxide film at a speed of 150 rpm for 60 seconds, and performing the process of polishing 100 wafer sheets under the above conditions, and the measured surface roughness difference (dRa2) is 3 to 4, preferably 3.1 to 3.7, and more preferably 3.2 to 3.6.

The window for end-point detection has a surface roughness difference (wSRD) represented by the following Equation 2 of 0.3 to 1.5, preferably 0.3 to 1.4:

$$[\text{Equation 2}]$$

$$wSRD = |Ra_{wi} - Ra_{wf}|$$

where,

Ra$_{wi}$ is a surface roughness (Ra) of the window before polishing, and
Ra$_{wf}$ is a surface roughness (Ra) of the window measured after supplying a calcined ceria slurry as the polishing layer at 200 mL/min, maintaining a wafer load of 41.4 kPa (6.0 psi), polishing an oxide film at a speed of 150 rpm for 60 seconds, and polishing 100 wafer sheets under the above conditions.

The window included in the polishing pad according to the present disclosure has a surface roughness difference between before and after the polishing process of 0.3 to 1.5 in absolute value, and the change in surface roughness due to the polishing process is not large so that the transmittance is not affected. The transmittance of the window for end-point detection included in the conventional polishing pad has been evaluated before being applied to the polishing process so that the performance for end-point detection has been confirmed. As described above, when the surface roughness of the window is affected by the polishing process, the light transmittance is changed, which may cause a problem of performance deterioration for end-point detection.

The window according to the present disclosure is characterized in that the degree of change in surface roughness between before and after the progress of the polishing process is not large so that the performance for end-point detection is not affected.

Further, the surface roughness of the polishing layer has a surface roughness difference (pSRD) value represented by the following Equation 3 of 1 to 4, preferably 1.5 to 3.5:

$$[\text{Equation 3}]$$

$$pSRD = |Ra_{pi} - Ra_{pf}|$$

where,

Ra$_{pi}$ is a surface roughness (Ra) of the polishing layer before polishing, and
Ra$_{pf}$ is a surface roughness (Ra) of the polishing layer measured after supplying a calcined ceria slurry as the polishing layer at 200 mL/min, maintaining a wafer load of 41.4 kPa (6.0 psi), polishing an oxide film at a speed of 150 rpm for 60 seconds, and polishing 100 wafer sheets under the above conditions.

As described above, not only the window for end-point detection, but also the polishing layer in the polishing pad according to the present disclosure is characterized in that the degree of change in surface roughness due to the polishing process is not large.

That is, as described above, if the changes in the surface roughness of the polishing layer and the surface roughness of the window between before and after the polishing process are included within a certain range, the polishing performance is not affected, and the degree of change in the surface roughness of the window between before and after the polishing process is also insignificant so that a difference in light transmittance is not shown, and thus it may be said that the effect on the end-point detection performance is insignificant.

In an embodiment, the window for end-point detection may include a cured product obtained by curing a window composition comprising a urethane-based prepolymer and a curing agent.

Further, in an embodiment, the polishing layer may include a polishing layer containing a cured product formed from a composition comprising a urethane-based prepolymer, a curing agent, and a foaming agent.

In a point that the window for end-point detection is formed of the same composition as the polishing layer composition except for the foaming agent included in the manufacturing of the polishing layer, the respective components of the window and the polishing layer will be described below.

The term 'prepolymer' refers to a polymer having a relatively low molecular weight in which the polymerization degree is stopped at an intermediate stage to facilitate molding in the production of a cured product. The prepolymer may be molded into a final cured product either on its own or after reacting with other polymerizable compounds.

In an embodiment, the urethane-based prepolymer may be prepared by reacting an isocyanate compound with a polyol.

As the isocyanate compound used in the preparation of the urethane-based prepolymer, one selected from the group consisting of aromatic diisocyanate, aliphatic diisocyanate, cycloaliphatic diisocyanate, and combinations thereof may be used.

The isocyanate compound may include, for example, one selected from the group consisting of 2,4-toluene diisocyanate (2,4-TDI), 2,6-toluene diisocyanate (2,6-TDI), naphthalene-1,5-diisocyanate, p-phenylene diisocyanate, tolidine diisocyanate, 4,4'-diphenylmethane diisocyanate, hexamethylene diisocyanate, dicyclohexylmethane diisocyanate, isophorone diisocyanate, and combinations thereof.

The 'polyol' refers to a compound containing at least two hydroxyl groups (-OH) per molecule. The polyol may include, for example, one selected from the group consisting of polyether polyols, polyester polyols, polycarbonate polyols, acrylic polyols, and combinations thereof.

The polyol may include, for example, one selected from the group consisting of polytetramethylene ether glycol, polypropylene ether glycol, ethylene glycol, 1,2-propylene glycol, 1,3-propylene glycol, 1,2-butanediol, 1,3-butanediol, 2-methyl-1,3-propanediol, 1,4-butanediol, neopentyl glycol, 1,5-pentanediol, 3-methyl-1,5-pentanediol, 1,6-hexanediol, diethylene glycol, dipropylene glycol, tripropylene glycol, and combinations thereof.

The polyol may have a weight average molecular weight (Mw) of about 100 g/mol to about 3,000 g/mol. The polyol may have a weight average molecular weight (Mw) of, for example, about 100 g/mol to about 3,000 g/mol, for example, about 100 g/mol to about 2,000 g/mol, or for example, about 100 g/mol to about 1,800 g/mol.

In an embodiment, the polyol may include a low molecular weight polyol having a weight average molecular weight (Mw) of about 100 g/mol or more and about less than 300 g/mol, and a high molecular weight polyol having a weight average molecular weight (Mw) of about 300 g/mol or more and about 1,800 g/mol or less.

The urethane-based prepolymer may have a weight average molecular weight (Mw) of about 500 g/mol to about 3,000 g/mol. The urethane-based prepolymer may have, for example, a weight average molecular weight (Mw) of about 600 g/mol to about 2,000 g/mol, for example, about 800 g/mol to about 1,000 g/mol.

In an embodiment, the isocyanate compound for preparing the urethane-based prepolymer may include an aromatic diisocyanate compound, and the aromatic diisocyanate compound may include, for example, 2,4-toluene diisocyanate (2,4-TDI) and 2,6-toluene diisocyanate (2,6-TDI). The polyol compound for preparing the urethane-based prepolymer may include polytetramethylene ether glycol (PTMEG) and diethylene glycol (DEG).

In another embodiment, the isocyanate compound for preparing the urethane-based prepolymer may include an aromatic diisocyanate compound and a cycloaliphatic diisocyanate compound, for example, the aromatic diisocyanate compound may include 2,4-toluene diisocyanate (2,4-TDI) and 2,6-toluene diisocyanate (2,6-TDI), and the cycloaliphatic diisocyanate compound may include dicyclohexylmethane diisocyanate (H12MDI). The polyol compound for preparing the urethane-based prepolymer may include polytetramethylene ether glycol (PTMEG) and diethylene glycol (DEG).

The urethane-based prepolymer may have an isocyanate end group content (NCO%) of about 5% by weight to about 11% by weight, for example, about 5% by weight to about 10% by weight, for example, about 5% by weight to about 8% by weight, or for example, about 8% by weight to about 10% by weight. When the urethane-based prepolymer has the NCO% within the above range, appropriate physical properties of the polishing layer in the polishing pad are exhibited so that the polishing performance required for the polishing process such as the polishing rate and the polishing profile may be maintained, and defects that may be generated on the wafer in the polishing process may be minimized.

The polishing selectivities (Ox RR/Nt RR) of oxide films and nitride films are controlled so that dishing, recess and erosion phenomena may be prevented, and surface planarization within the wafer may be achieved.

Further, when the urethane-based prepolymer is applied as a window for end-point detection, the degree of change in surface roughness in the polishing process is small so that the effect on the performance for end-point detection is insignificant.

The isocyanate end group content (NCO%) of the urethane-based prepolymer may be designed by comprehensively controlling the type and content of the isocyanate compound and polyol compound for preparing the urethane-based prepolymer, the process conditions such as temperature, pressure, and time of the process of preparing the urethane-based prepolymer, and the type and content of additives used in the preparation of the urethane-based prepolymer.

The curing agent is a compound for chemically reacting with the urethane-based prepolymer to form a final cured structure in the polishing layer, and may include, for example, an amine compound or an alcohol compound. Specifically, the curing agent may include one selected from the group consisting of aromatic amines, aliphatic amines, aromatic alcohols, aliphatic alcohols, and combinations thereof.

For example, the curing agent may include one selected from the group consisting of 4,4'-methylenebis(2-chloroaniline) (MOCA), diethyltoluenediamine (DETDA), diaminodiphenylmethane, dimethyl thio-toluene diamine (DMTDA), propanediol bis(p-aminobenzoate), methylene bis(methyl anthranilate), diaminodiphenyl sulfone, m-xylylenediamine, isophorone diamine, ethylenediamine, diethylenetriamine, triethylenetetramine, polypropylenediamine, polypropylene triamine, bis(4-amino-3-chlorophenyl)methane, and combinations thereof.

The content of the curing agent may be about 18 parts by weight to about 27 parts by weight, for example, about 19 parts by weight to about 26 parts by weight, or for example, about 20 parts by weight to about 26 parts by weight based on 100 parts by weight of the urethane-based prepolymer. When the content of the curing agent satisfies the above range, it may be more advantageous in realizing the desired performance of the polishing pad.

The foaming agent may include one selected from the group consisting of a solid-phase foaming agent, a gas-phase foaming agent, a liquid-phase foaming agent, and combinations thereof as a component for forming a pore structure in the polishing layer.

As described above, since, when the window for end-point detection is manufactured, a pore structure is not formed unlike the manufacturing of the polishing layer, a separate foaming agent is not contained.

In an embodiment, the foaming agent may include a solid-phase foaming agent, a gas-phase foaming agent, or a combination thereof.

The solid-phase foaming agent may have an average particle diameter of about 5 $\mu$m to about 200 $\mu$m, for example, about 20 $\mu$m to about 50 $\mu$m, for example, about 21 $\mu$m to about 50 $\mu$m, or for example, about 25 $\mu$m to about 45 $\mu$m. The average particle diameter of the solid-phase foaming agent may mean an average particle diameter of the thermally expanded particles themselves when the solid-phase foaming agent is thermally expanded particles as described below, and the average particle diameter of the solid-phase foaming agent may mean an average particle diameter of the particles after being expanded by heat or pressure when the solid-phase foaming agent is unexpanded particles as described below.

The solid-phase foaming agent may comprise expandable particles. The expandable particles are particles having properties of being expandable by heat or pressure, and the size of the expandable particles in the final polishing layer may be determined by heat or pressure applied in the process of manufacturing the polishing layer. The expandable particles may include thermally expanded particles, unexpanded particles, or a combination thereof. The thermally expanded particles are particles that have been preliminarily expanded by heat, and refer to particles having little or no size change due to heat or pressure applied in the process of manufacturing the polishing layer. The unexpanded particles are particles that have not been preliminarily expanded, and refer to particles which are expanded by heat or pressure applied in the process of manufacturing the polishing layer so that their final size is determined.

The expandable particles may comprise a resin material outer sheath; and an expansion-inducing component present in the inside enclosed by the outer sheath.

For example, the outer sheath may include a thermoplastic resin, and the thermoplastic resin may be one or more selected from the group consisting of vinylidene chloride-based copolymers, acrylonitrile-based copolymers, methacrylonitrile-based copolymers, and acrylic copolymers.

The expansion-inducing component may include one selected from the group consisting of a hydrocarbon compound, a chlorofluoro compound, a tetraalkylsilane compound, and combinations thereof.

Specifically, the hydrocarbon compound may include one selected from the group consisting of ethane, ethylene, propane, propene, n-butane, isobutene, n-butene, isobutene, n-pentane, isopentane, neopentane, n-hexane, heptane, petroleum ether, and combinations thereof.

The chlorofluoro compound may include one selected from the group consisting of trichlorofluoromethane ($CCl_3F$), dichlorodifluoromethane ($CCl_2F_2$), chlorotrifluoromethane ($CClF_3$), tetrafluoroethylene ($CClF_2$-$CClF_2$), and combinations thereof.

The tetraalkylsilane compound may include one selected from the group consisting of tetramethylsilane, trimethylethylsilane, trimethylisopropylsilane, trimethyl-n-propylsilane, and combinations thereof.

The solid-phase foaming agent may optionally comprise inorganic component-treated particles. For example, the solid-phase foaming agent may comprise inorganic component-treated expandable particles. In an embodiment, the solid-phase foaming agent may comprise silica ($SiO_2$) particle-treated expandable particles. The inorganic component treatment of the solid-phase foaming agent may prevent aggregation between a plurality of particles. The inorganic component-treated solid-phase foaming agent may have chemical, electrical and/or physical properties of the surface of the foaming agent different from those of an inorganic component-untreated solid-phase foaming agent.

The content of the solid-phase foaming agent may be about 0.5 parts by weight to about 10 parts by weight, for example, about 1 part by weight to about 3 parts by weight, for example, about 1.3 parts by weight to about 2.7 parts by weight, or for example, about 1.3 parts by weight to about 2.6 parts by weight based on 100 parts by weight of the urethane-based prepolymer.

The type and content of the solid-phase foaming agent may be designed depending on the desired pore structure and physical properties of the polishing layer.

The gas-phase foaming agent may include an inert gas. The gas-phase foaming agent may be used as a pore-forming element by being injected in the process of reacting the urethane-based prepolymer and the curing agent.

The type of the inert gas is not particularly limited as long as it is a gas that does not participate in the reaction between the urethane-based prepolymer and the curing agent. For example, the inert gas may include one selected from the group consisting of nitrogen gas ($N_2$), argon gas (Ar), helium gas (He), and combinations thereof. Specifically, the inert gas may include nitrogen gas ($N_2$) or argon gas (Ar).

The type and content of the gas-phase foaming agent may be designed depending on the desired pore structure and physical properties of the polishing layer.

In an embodiment, the foaming agent may include a solid-phase foaming agent. For example, the foaming agent may consist only of a solid-phase foaming agent.

The solid-phase foaming agent may comprise expandable particles, and the expandable particles may include thermally expanded particles. For example, the solid-phase foaming agent may consist only of thermally expanded particles. When the solid-phase foaming agent consists only of thermally expanded particles without comprising the unexpanded particles, the variability of the pore structure is reduced, but the predictability is increased so that it may be advantageous to implement homogeneous pore properties over the entire area of the polishing layer.

In an embodiment, the thermally expanded particles may be particles having an average particle diameter of about 5 $\mu$m to about 200 $\mu$m. The thermally expanded particles may have an average particle diameter of about 5 $\mu$m to about 100 $\mu$m, for example, about 10 $\mu$m to about 80 $\mu$m, for example, about 20 $\mu$m to about 70 $\mu$m, for example, about 20 $\mu$m to about 50 $\mu$m, for example, about 30 $\mu$m to about 70 $\mu$m, for example, about 25 $\mu$m to about 45 $\mu$m, for example, about 40 $\mu$m to about 70 $\mu$m, or for example, about 40 $\mu$m to about 60 $\mu$m. The average particle diameter is defined as D50 of the thermally expanded particles.

In an embodiment, the thermally expanded particles may have a density of about 30 kg/m$^3$ to about 80 kg/m$^3$, for example, about 35 kg/m$^3$ to about 80 kg/m$^3$, for example, about 35 kg/m$^3$ to about 75 kg/m$^3$, for example, about 38 kg/m$^3$ to about 72 kg/m$^3$, for example, about 40 kg/m$^3$ to about 75 kg/m$^3$, or for example, about 40 kg/m$^3$ to about 72 kg/m$^3$.

In an embodiment, the foaming agent may include a gas-phase foaming agent. For example, the foaming agent may include a solid-phase foaming agent and a gas-phase foaming agent. Matters regarding the solid-phase foaming agent are the same as described above.

The gas-phase foaming agent may include nitrogen gas.

The gas-phase foaming agent may be injected through a predetermined injection line during a process that the urethane-based prepolymer, the solid-phase foaming agent, and the curing agent are mixed. The gas-phase forming agent may have an injection rate of about 0.8 L/min to about 2.0 L/min, for example, about 0.8 L/min to about 1.8 L/min, for example, about 0.8 L/min to about 1.7 L/min, for example, about 1.0 L/min to about 2.0 L/min, for example, about 1.0 L/min to about 1.8 L/min, or for example, about 1.0 L/min to about 1.7 L/min.

The composition for manufacturing the polishing layer and the window may further comprise other additives such as a surfactant and a reaction rate controlling agent. The names such as 'surfactant' and 'reaction rate controlling agent' are names arbitrarily called based on the main roles of the corresponding substances, and each of the corresponding substances does not necessarily perform only a function limited to the role by the corresponding name.

The surfactant is not particularly limited as long as it is a material that serves to prevent a phenomenon such as aggregation or overlapping of pores. For example, the surfactant may include a silicone-based surfactant.

The surfactant may be used in an amount of about 0.2 parts by weight to about 2 parts by weight based on 100 parts by weight of the urethane-based prepolymer. Specifically, the surfactant may be contained in an amount of about 0.2 parts by weight to about 1.9 parts by weight, for example, about 0.2 parts by weight to about 1.8 parts by weight, for example, about 0.2 parts by weight to about 1.7 parts by weight, for example, about 0.2 parts by weight to about 1.6 parts by weight, for example, about 0.2 parts by weight to about 1.5 parts by weight, or for example, about 0.5 parts by weight to 1.5 parts by weight based on 100 parts by weight of the urethane-based prepolymer. When the surfactant is contained in an amount within the above range, pores derived from the gas-phase foaming agent may be stably formed and maintained in the mold.

The reaction rate controlling agent is one which serves to promote or delay the reaction, and a reaction accelerator, a reaction retarder, or both thereof may be used depending on the purpose. The reaction rate controlling agent may include a reaction accelerator. For example, the reaction accelerator may be one or more reaction accelerators selected from the group consisting of tertiary amine-based compounds and organometallic compounds.

Specifically, the reaction rate controlling agent may include one or more selected from the group consisting of triethylenediamine, dimethylethanolamine, tetramethylbutanediamine, 2-methyl triethylenediamine, dimethylcyclohexylamine, triethylamine, triisopropanolamine, 1,4-diazabicyclo(2,2,2)octane, bis(2-methylaminoethyl)ether, trimethylaminoethylethanolamine, N,N,N',N",N"-pentamethyldiethylenetriamine, dimethylaminoethylamine, dimethylaminopropylamine, benzyldimethylamine, N-ethylmorpholine, N,N-dimethylaminoethylmorpholine, N,N-dimethylcyclohexylamine, 2-methyl-2-azanorbornane, dibutyltin dilaurate, stannous octoate, dibutyltin diacetate, dioctyltin diacetate, dibutyltin maleate, dibutyltin di-2-ethylhexanoate, and dibutyltin dimercaptide. Specifically, the reaction rate controlling agent may include one or more selected from the group consisting of benzyldimethylamine, N,N-dimethylcyclohexylamine, and triethylamine.

The reaction rate controlling agent may be used in an amount of about 0.05 parts by weight to about 2 parts by weight based on 100 parts by weight of the urethane-based prepolymer. Specifically, the reaction rate controlling agent may be used in an amount of about 0.05 parts by weight to about 1.8 parts by weight, for example, about 0.05 parts by weight to about 1.7 parts by weight, for example, about 0.05 parts by weight to about. 1.6 parts by weight, for example, about 0.1 parts by weight to about 1.5 parts by weight, for example, about 0.1 parts by weight to about 0.3 parts by weight, for example, about 0.2 parts by weight to about 1.8 parts by weight, for example, about 0.2 parts by weight to about 1.7 parts by weight, for example, about 0.2 parts by weight to about 1.6 parts by weight, for example, about 0.2 parts by weight to about 1.5 parts by weight, or for example, about 0.5 parts by weight to about 1 part by weight based on 100 parts by weight of the urethane-based prepolymer. When the reaction rate controlling agent is used in the above-described amount range, the curing reaction rate of the prepolymer composition may be appropriately adjusted to form a polishing layer having desired-sized pores and hardness.

When the polishing pad comprises a cushion layer, the cushion layer may minimize occurrence of damage and defects in a polishing target during the polishing process to which the polishing pad is applied by serving to absorb and disperse an external impact applied to the polishing layer while supporting the polishing layer.

The cushion layer may include a nonwoven fabric or suede, but the present disclosure is not limited thereto.

In an embodiment, the cushion layer may be a resin-impregnated nonwoven fabric. The nonwoven fabric may be a fiber nonwoven fabric including one selected from the group consisting of polyester fibers, polyamide fibers, polypropylene fibers, polyethylene fibers, and combinations thereof.

The resin impregnated into the nonwoven fabric may include one selected from the group consisting of a polyurethane resin, a polybutadiene resin, a styrene-butadiene copolymer resin, a styrene-butadiene-styrene copolymer resin, an acrylonitrile-butadiene copolymer resin, a styrene-ethylene-butadiene-styrene copolymer resin, a silicone rubber resin, a polyester-based elastomer resin, a polyamide-based elastomer resin, and combinations thereof.

Hereinafter, the method for manufacturing the polishing pad will be described in detail.

A method of manufacturing a polishing pad according to the present invention is defined in claim 9.

The step of preparing the prepolymer composition may be a process of preparing a urethane-based prepolymer by reacting a diisocyanate compound and a polyol compound. Matters regarding the diisocyanate compound and the polyol compound are the same as those described above with respect to the polishing pad.

The prepolymer composition may have an isocyanate group (NCO group) content of about 5% by weight to about 15% by weight, for example, about 5% by weight to about 8% by weight, for example, about 5% by weight to about 7% by weight, for example, about 8% by weight to about 15% by weight, for example, about 8% by weight to about 14% by weight, for example, about 8% by weight to about 12% by weight, or for example, about 8% by weight to about 10% by weight.

The isocyanate group content of the prepolymer composition may be derived from terminal isocyanate groups of the urethane-based prepolymer, unreacted isocyanate groups which have not been reacted in the diisocyanate compound, and the like.

The prepolymer composition may have a viscosity of about 100 cps to about 1,000 cps, for example, about 200 cps to about 800 cps, for example, about 200 cps to about 600 cps, for example, about 200 cps to about 550 cps, or for example, about 300 cps to about 500 cps at about 80°C.

The foaming agent may include a solid-phase foaming agent or a gas-phase foaming agent.

When the foaming agent includes a solid-phase foaming agent, the step of preparing the composition for polishing layer manufacturing may include steps of: preparing a first preliminary composition by mixing the prepolymer composition and the solid-phase foaming agent; and preparing a second preliminary composition by mixing the first preliminary composition and a curing agent.

The first preliminary composition may have a viscosity of about 1,000 cps to about 2,000 cps, for example, about 1,000 cps to about 1,800 cps, for example, about 1,000 cps to about 1,600 cps, or for example, about 1,000 cps to about 1,500 cps at about 80°C.

When the foaming agent includes a gas-phase foaming agent, the step of preparing the composition for polishing layer manufacturing may include steps of: preparing a third preliminary composition comprising the prepolymer composition and the curing agent; and preparing a fourth preliminary composition by injecting the gas-phase foaming agent into the third preliminary composition.

In an embodiment, the third preliminary composition may further comprise a solid-phase foaming agent.

In an embodiment, the process of manufacturing the window may comprise steps of: preparing a mold preheated to a first temperature; injecting the composition for window manufacturing into the preheated mold and curing the composition for window manufacturing; and post-curing the cured composition for window manufacturing under a second temperature condition higher than the preheating temperature.

In an embodiment, the process of manufacturing the polishing layer may comprise steps of: preparing a mold preheated to a first temperature; injecting the composition for polishing layer manufacturing into the preheated mold and curing the composition for polishing layer manufacturing; and post-curing the cured composition for polishing layer manufacturing under a second temperature condition higher than the preheating temperature.

In an embodiment, the first temperature may be about 60°C to about 100 °C, for example, about 65°C to about 95°C, or for example, about 70°C to about 90°C.

In an embodiment, the second temperature may be about 100°C to about 130°C, for example, about 100°C to 125°C, or for example, about 100°C to about 120°C.

The step of curing the composition for window manufacturing and the composition for polishing layer manufacturing under the first temperature may be performed for about 5 minutes to about 60 minutes, for example, about 5 minutes to about 40 minutes, for example, about 5 minutes to about 30 minutes, or for example, about 5 minutes to about 25 minutes.

The step of post-curing the composition cured under the first temperature under the second temperature may be performed for about 5 hours to about 30 hours, for example, about 5 hours to about 25 hours, for example, about 10 hours to about 30 hours, for example, about 10 hours to about 25 hours, for example, about 12 hours to about 24 hours, or for example, about 15 hours to about 24 hours.

The cured composition is prepared in the form of a sheet, and a forming process is carried out in order for the window in the form of the sheet to be inserted and adhered to the perforated polishing layer.

The step of forming the window comprises primarily forming the thickness of the cured window sheet by using a bite having a curvature of 0.3 to 5 mm at a corner portion thereof and performing secondary forming with an embossed mold.

More specifically, in the step of forming the thickness of the window sheet, a bite having a curvature of the corner portion of 0.3 to 5 mm, or preferably a curvature of the corner portion of 0.5 to 3 mm is used, and more preferably, an industrial PCD (Polycrystalline Diamond) bite having a curvature of the corner portion of 0.5 to 3 mm is used.

The PCD bite is a tool made by sintering a micro-sized artificial diamond at ultrahigh pressure and high temperatures. Usually, carbide is used for the body thereof, and PCD is attached only to a tip portion or blade portion thereof. The PCD bite has abrasion resistance suitable for work for non-ferrous metals so that it may be used for processing difficult-to-cut materials such as copper, magnesium, aluminum, copper, reinforced plastics, and ceramics.

In order to form the thickness of the window in the present disclosure, the top and bottom surfaces of the cured window sheet are primarily formed using a PCD bite, and it may be said to be possible to manufacture the window to have a uniform surface roughness by performing forming using the PCD bite during the primary forming.

Meanwhile, when using a bite made with a general blade without using the above-described PCD bite, it is impossible to form the thickness to have a uniform surface roughness, unlike the PCD bite. That is, when the window sheet is primarily formed, the forming process is performed on one surface that comes into contact with the polishing surface. Therefore, when the top and bottom surfaces are formed using a general blade, precise forming is impossible so that they may be manufactured into a rough surface.

As described above, the cured window sheet is manufactured into a window for end-point detection by primarily forming the cured window sheet using a PCD bite and then performing secondary forming of cutting it with an embossed mold.

The method for manufacturing the polishing pad may comprise a step of processing at least one surface of the polishing layer. The processing step may be forming a groove.

In another embodiment, the step of processing at least one surface of the polishing layer may include at least one step of: a step (1) of forming a groove on at least one surface of the polishing layer; a step (2) of line-turning the at least one surface of the polishing layer; and a step (3) of roughening the at least one surface of the polishing layer.

In the step (1), the groove may include at least one of: a concentric circular groove formed spaced apart from the center of the polishing layer at predetermined intervals; and a radial groove continuously connected from the center of the polishing layer to an edge of the polishing layer.

In the step (2), the line turning may be performed by a method of cutting the polishing layer by a predetermined thickness using a cutting tool.

In the step (3), the roughening may be performed by a method of processing the surface of the polishing layer with a sanding roller.

The method for manufacturing the polishing pad may further comprise a step of laminating a cushion layer on the back surface of the polishing surface of the polishing layer.

The polishing layer and the cushion layer may be laminated through a heat-sealing adhesive.

After the heat-sealing adhesive is applied onto the back surface of the polishing surface of the polishing layer, the heat-sealing adhesive is applied onto the surface of the cushion layer to be in contact with the polishing layer, and the polishing layer and the cushion layer are stacked so that the respective surfaces onto which the heat-sealing adhesive has been applied come into contact with each other, the two layers may be fused using a pressure roller.

In another embodiment, the method comprises steps of: providing a polishing pad including a polishing layer; polishing the polishing target while rotating the polishing layer relative to a polishing target so that the surface to be polished of the polishing target is in contact with the polishing surface of the polishing layer; and detecting the thickness of the semiconductor substrate through the window for end-point detection in the polishing pad and detecting the end point of the polishing process.

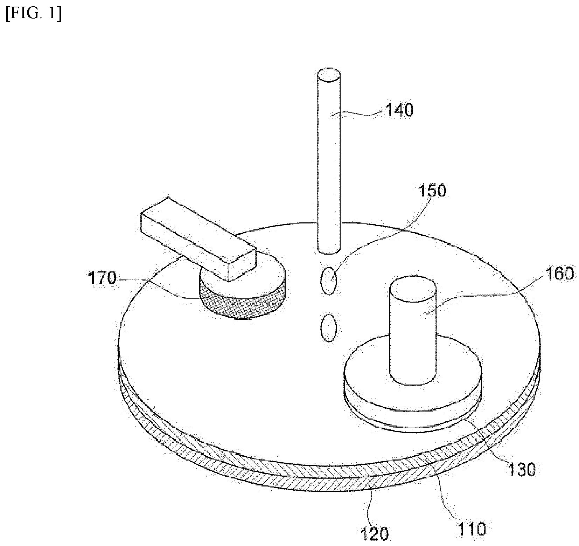

FIG. 1 shows a schematic process diagram of a semiconductor device manufacturing process according to an embodiment. Referring to FIG. 1, after a polishing pad 110 according to the embodiment is mounted on a surface plate 120, a semiconductor substrate 130 that is a polishing target is disposed on the polishing pad 110. In this case, a surface to be polished of the semiconductor substrate 130 is in direct contact with the polishing surface of the polishing pad 110. For polishing, a polishing slurry 150 may be sprayed onto the polishing pad through a nozzle 140. The flow rate of the polishing slurry 150 supplied through the nozzle 140 may be selected depending on the purpose within a range of about 10 cm$^3$/min to about 1,000 cm$^3$/min, for example, about 50 cm$^3$/min to about 500 cm$^3$/min, but the present disclosure is not limited thereto.

Thereafter, the semiconductor substrate 130 and the polishing pad 110 may be rotated relative to each other so that the surface of the semiconductor substrate 130 may be polished. In this case, the rotation direction of the semiconductor substrate 130 and the rotation direction of the polishing pad 110 may be the same direction or opposite directions. The rotation speeds of the semiconductor substrate 130 and the polishing pad 110 may be each selected depending on the purpose in a range of about 10 rpm to about 500 rpm, and may be, for example, about 30 rpm to about 200 rpm, but the present disclosure is not limited thereto.

After the semiconductor substrate 130 is pressed against the polishing surface of the polishing pad 110 by a predetermined load in a state that the semiconductor substrate 130 is mounted on the polishing head 160, so that the semiconductor substrate 130 comes into contact with the polishing surface of the polishing pad 110, the surface of the semiconductor substrate 130 may be polished. The load applied to the polishing surface of the polishing pad 110 on the surface of the semiconductor substrate 130 by the polishing head 160 may be selected depending on the purpose in a range of about 1 gf/cm$^2$ to about 1,000 gf/cm$^2$, and may be, for example, about 10 gf/cm$^2$ to about 800 gf/cm$^2$, but the preset disclosure is not limited thereto.

Whether the polishing target film of the semiconductor substrate 130 is polished to a predetermined thickness confirms the polishing degree and determines the polishing end-point by light of the optical sensor unit (not shown) in the polishing equipment, that is emitted through the window (not shown) in the polishing pad.

In an embodiment, in order to maintain the polishing surface of the polishing pad 110 in a state suitable for polishing, the method for manufacturing the semiconductor device may further comprise a step of polishing the semiconductor substrate 130 and at the same time processing the polishing surface of the polishing pad 110 through the conditioner 170.

Hereinafter, specific Examples of the present disclosure are presented. However, the Examples described below are only for specifically illustrating or explaining the present disclosure, and the method of manufacturing of the polishing pad is defined in claim 9.

**Example 1**

**Manufacturing of Polishing Pad**

**1-1. Manufacturing of Polishing Layer**

In casting equipment including an injection line of a mixture of a urethane-based prepolymer, a curing agent, and a solid-phase foaming agent, a prepolymer tank was charged with a urethane-based prepolymer having 9% by weight of unreacted NCO, and a curing agent tank was charged with bis(4-amino-3-chlorophenyl)methane (a product of Ishihara). Further, 3 parts by weight of a solid-phase foaming agent was mixed in advance with respect to 100 parts by weight of the urethane-based prepolymer and then injected into the prepolymer tank.

The urethane-based prepolymer and MOCA were stirred while being injected into the mixing head at a constant speed through each of the injection lines. At this time, the molar equivalent of the NCO group of the urethane-based prepolymer and the molar equivalent of the reactive group of the curing agent were adjusted to 1:1, and the total injection amount was maintained at a rate of 10 kg/min.

The stirred raw material was injected into a mold preheated to 120°C, and manufactured into a single porous polyurethane sheet. Thereafter, the surface of the manufactured porous polyurethane sheet was ground using a grinding machine, and the porous polyurethane sheet was manufactured to an average thickness of 2 mm and an average diameter of 76.2 cm through a grooving process using a tip.

### 1-2. Manufacturing of Window

A window was manufactured in the same manner as in Example 1-1 except that PUGL-500D (a product of SKC) with an unreacted NCO content of 8.5% by weight as a urethane-based prepolymer was used, an inert gas was not injected when mixing raw materials, and the injected raw materials were injected into a post-mold (a width of 1,000 mm, a length of 1,000 mm, and a height of 50 mm). In order to match the thickness of the top and bottom surfaces of the window formed in the form of a sheet, it was formed to a thickness of 2.0 mm using a bite made of industrial PCD diamond having a flat cutting surface shape and a curvature at the corner portion of 0.5 mm, and then cut with an embossed mold with sizes of a width of 20 mm and a length of 60 mm made of SKD11 steel for cold forming.

### 1-3. Support Layer

1.1 A nonwoven type support layer (manufacturer: PTS, product name: ND-5400H) having a thickness of T was used.

### 1-4. Manufacturing of Polishing Pad

The polishing layer of Example 1-1 above was perforated to a width of 20 mm and a length of 60 mm to form a first through-hole, and the support layer of Example 1-3 above was perforated to a width of 16 mm and a length of 56 mm to form a second through-hole. Thereafter, the support layer and the polishing layer were heat-sealed at 120°C using a hot melt film (manufacturer: SKC, product name: TF-00), a double-sided adhesive (manufacturer: 3M, product name: 442JS) was adhered to the other surface of the support layer, and the double-sided adhesive was cut and removed as much as the second through-hole. Thereafter, the double-sided adhesive was cut and removed as much as the second through-hole, and the window of Example 1-2 was inserted into the first through-hole and adhered to the double-sided adhesive to manufacture a polishing pad.

### Example 2

1-1, 1-3, and 1-4 of Example 1 above were manufactured in the same manner, and manufacturing of the window block was performed as follows. A window was manufactured in the same manner as in Example 1-1 except that PUGL-500D (a product of SKC) with an unreacted NCO content of 8.5% by weight as a urethane-based prepolymer was used, an inert gas was not injected when mixing raw materials, and the injected raw materials were injected into a post-mold (a width of 1,000 mm, a length of 1,000 mm, and a height of 50 mm). In order to match the thickness of the top and bottom surfaces of the window formed in the form of a sheet, it was formed to a thickness of 2.0 mm using a bite made of industrial PCD diamond having a flat cutting surface shape and a curvature at the corner portion of 3 mm, and then cut using a mold in which the blade of the embossed mold made of a general steel plate with sizes of a width of 20 mm and a length of 60 mm was attached to a wooden flat plate body.

### Comparative Example 1

1-1, 1-3, and 1-4 of Example 1 above were manufactured in the same manner, and manufacturing of the window block was performed as follows. A window was manufactured in the same manner as in Example 1-1 except that PUGL-500D (a product of SKC) with an unreacted NCO content of 8.5% by weight as a urethane-based prepolymer was used, an inert gas was not injected when mixing raw materials, and the injected raw materials were injected into a post-mold (a width of 1,000 mm, a length of 1,000 mm, and a height of 50 mm). In order to match the thickness of the top and bottom surfaces of the window in the form of a sheet, it was formed to a thickness of 2.0 mm using a bite made of a general blade having a flat cutting surface shape and a curvature at the corner portion of 3 mm, and then cut using a mold in which the blade of the embossed mold made of a general steel plate with sizes of a width of 20 mm and a length of 60 mm was attached to a wooden flat plate body.

### Experimental Example 1

**Measurement of Surface Roughness**

Silicon oxide was deposited on a silicon wafer having a diameter of 300 mm by a chemical vapor deposition (CVD) process. The polishing pads of Example and Comparative Example were attached to CMP equipment, and an oxide layer of the silicon wafer was installed to face the polishing surface of the polishing pads. A dummy wafer was polished for 6,000 seconds at a load of 41.4 kPa (6.0 psi) and a speed of 150 rpm while supplying the calcined ceria slurry onto the polishing pads at a rate of 200 mL/min. At this time, conditioner CI-45 (Saesol Diamond Ind. Co., Ltd) was used in-situ, and conditioning was performed with a load of 2.72 kg (6 lb).

Polishing and conditioning conditions

Calcined ceria slurry composition: 0.5% by weight of calcined ceria, 99.4% by weight of DI water, and 0.1% by weight of polyacrylate-based additive
Calcined ceria: 150 nm (measured by scattering method)
Conditioner specification: CI-45 (Saesol Diamond Ind. Co., Ltd)

The surface plate rotation speed, the conditioner rotation speed, the conditioner precession speed, and conditions are shown in Table 1 below.

[Table 1]

| Classification | Detail | Specification |
|---|---|---|
| Wafer | Wafer type | PETEOS |
| | Dummy(Polishing time/ Number of time) | 6000s/∞ |
| Break In | Time | 15 min |
| Head & Platen | Head speed (rpm) | 87 |
| | Head pressure (psi) | 3.5 |
| | Retainer Ring pressure (psi) | 9 psi |
| | Platen speed (rpm) | 93.0 |
| | Spindle sweep speed (sw/min) | 19.0 |
| Conditioner | Conditioner type | CI-45 |
| | Conditioning type | In situ (300s) + Ex situ (15s) |
| | Conditioner force (lb) | 6 lb |
| | Conditioner speed (rpm) | 101.0 |
| | Conditioner sweep speed (sw/min) | 19.0 |
| Slurry | Slurry type | Ceria slurry |

After the polishing process, surface roughness values of the polishing layer and the window were measured for Examples and Comparative Example. The surface roughness values were measured in three dimensions using ContuorGT (Bruker).

[Table 2]

| | | Unit | Example 1 | Example 2 | Comparative Example |
|---|---|---|---|---|---|
| Window | Ra before polishing | um | 0.372 | 1.046 | 2.546 |
| | Ra after polishing | um | 1.710 | 1.391 | 1.665 |
| | $|Ra_{wi}-Ra_{wf}|$ | um | 1.338 | 0.345 | 0.881 |

(continued)

| | | Unit | Example 1 | Example 2 | Comparative Example |
|---|---|---|---|---|---|
| Polishing layer | Ra before polishing | um | 7.218 | 7.814 | 7.734 |
| | Ra after polishing | um | 5.260 | 4.614 | 5.155 |
| | $|Ra_{pi}-Ra_{pf}|$ | um | 1.958 | 3.200 | 2.579 |
| dRa1 | | um | 6.846 | 6.768 | 5.188 |
| dRa2 | | um | 3.550 | 3.223 | 3.49 |
| dRa1/dRa2 | | | 1.928 | 2.100 | 1.487 |
| $Ra_{wi}$ is the surface roughness (Ra) of the window before polishing, $Ra_{wf}$ is the surface roughness (Ra) of the window after polishing, $Ra_{pi}$ is the surface roughness (Ra) of the polishing layer before polishing, $Ra_{pf}$ is the surface roughness (Ra) of the polishing layer after polishing, dRa1 is the surface roughness difference between the polishing layer and the window before polishing, and dRa2 is the surface roughness difference between the polishing layer and the window after polishing. | | | | | |

According to Table 1 above, it was confirmed that the polishing pad of the Example of the present disclosure did not show a significant difference between before and after the polishing process on the surface roughness measurement results for the window and the polishing layer.

Meanwhile, it was confirmed in the case of the Comparative Example that the window exhibited a relatively large value of surface roughness before polishing, and thus, it exhibited a large difference in surface roughness between before and after polishing. Therefore, compared with the polishing layer in the polishing pad, it was confirmed that a surface roughness rate of difference change (SRR) according to before and after the polishing process was not included in the scope of the present disclosure.

**Experimental Example 2**

**Evaluation of End-point Detection Performance**

The polishing pads of Example and Comparative Example were attached to CMP equipment, and an oxide layer of the silicon wafer was installed to face the polishing surface of the polishing pads. The wafer was polished by polishing the oxide film at a load of 41.4 kPa (6.0 psi) and a speed of 150 rpm while supplying the calcined ceria slurry onto the polishing pads at a rate of 200 mL/min. At this time, conditioner CI-45 (Saesol Diamond Ind. Co., Ltd) was used in-situ, and conditioning was performed with a load of 2.72 kg (6 lb). It was checked whether or not end-point detection was possible for the polishing pads of Examples and Comparative Example.

[Table 3]

| | Example 1 | Example 2 | Comparative Example |
|---|---|---|---|
| End-point detection | Possible | Possible | Error occurred |

As results of the above experiment, as results of carrying out the polishing process using the polishing pads of Examples and Comparative Example of the present disclosure, the end-point detection was possible through the window of the polishing pad within the polishing device in the case of Example 1, so that the completion of the polishing process was normally operated, but errors occurred in the case of Example 2 and Comparative Example so that the polishing process could not proceed.

Hereinabove, preferred embodiments of the present disclosure have been described in detail, but the right scope of the present disclosure is not limited thereto, and various modified and improved forms of those skilled in the art within the defined subject-matter of the appended claims, also belong to the right scope of the present disclosure.

[Explanation of reference numerals]

110: Polishing pad
120: Surface plate
130: Semiconductor substrate
140: Nozzle
150: Polishing slurry
160: Polishing head
170: Conditioner
200: Polishing layer
210: Surface roughness of the polishing surface before polishing
220: Surface roughness of the polishing surface after polishing
300: Window
310: Surface roughness of the window surface before polishing
320: Surface roughness of the window surface after polishing

**Claims**

1.  A polishing pad including a polishing layer and a window for end-point detection, **characterized in that** the surface roughness (Ra) of the polishing layer and the window for end-point detection has a surface roughness rate of difference change (SRR) represented by the following Equation 1 of 1.9 to 2.2:

    [Equation 1]

    $$SRR = \frac{dRa1}{dRa2}$$

    where,

    dRa1 is a surface roughness difference between the polishing layer and the window before polishing, and dRa2 is a surface roughness difference between the polishing layer and the window measured after supplying a calcined ceria slurry onto the polishing layer at 200 mL/min, maintaining a wafer load of 41.4 kPa (6.0 psi), polishing an oxide film at a speed of 150 rpm for 60 seconds, and polishing 100 wafer sheets under the above conditions.

2.  The polishing pad of claim 1, wherein the window for end-point detection has a surface roughness difference (wSRD) represented by the following Equation 2 of 0.3 to 1.5:

    [Equation 2]

    $$wSRD=|Ra_{wi}-Ra_{wf}|$$

    where,

    $Ra_{wi}$ is a surface roughness (Ra) of the window before polishing, and $Ra_{wf}$ is a surface roughness (Ra) of the window measured after supplying a calcined ceria slurry onto the polishing layer at 200 mL/min, maintaining a wafer load of 41.4 kPa (6.0 psi), polishing an oxide film at a speed of 150 rpm for 60 seconds, and polishing 100 wafer sheets under the above conditions.

3.  The polishing pad of claim 1 or 2, wherein the surface roughness of the polishing layer has a surface roughness difference (pSRD) value represented by the following Equation 3 of 1 to 4:

    [Equation 3]

    $$pSRD=|Ra_{pi}-Ra_{pf}|$$

    where,

$Ra_{pi}$ is a surface roughness (Ra) of the polishing layer before polishing, and
$Ra_{pf}$ is a surface roughness (Ra) of the polishing layer measured after supplying a calcined ceria slurry onto the polishing layer at 200 mL/min, maintaining a wafer load of 41.4 kPa (6.0 psi), polishing an oxide film at a speed of 150 rpm for 60 seconds, and polishing 100 wafer sheets under the above conditions.

4. The polishing pad of any one of claims 1 to 3, wherein the polishing layer and the window have a surface roughness difference (dRa1) before polishing of 6 to 7.

5. The polishing pad of any one of claims 1 to 4, wherein in the polishing layer and the window, surface roughness values of the polishing layer and the window are measured after supplying a calcined ceria slurry onto the polishing layer at 200 mL/min, maintaining a wafer load of 41.4 kPa (6.0 psi), polishing an oxide film at a speed of 150 rpm for 60 seconds, and performing the process of polishing 100 wafer sheets under the above conditions, and the measured surface roughness difference (dRa2) is 3 to 4.

6. The polishing pad of any one of claims 1 to 5, wherein the window includes a cured product obtained by curing a window composition comprising a urethane-based prepolymer and a curing agent.

7. The polishing pad of claim 6, wherein the urethane-based prepolymer has an unreacted NCO% of 8% by weight to 10% by weight.

8. The polishing pad of any one of claims 1 to 7, wherein the polishing layer contains a cured product obtained by curing a polishing composition comprising a urethane-based prepolymer, a curing agent, and a foaming agent.

9. A method for manufacturing a polishing pad as defined in any of claims 1 to 8, the method comprising steps of:

   i) preparing a urethane-based prepolymer composition;
   ii) preparing a composition for window manufacturing comprising the prepolymer composition and a curing agent;
   iii) manufacturing a window by curing the composition for window manufacturing; and
   iv) forming a through-hole in a polishing layer, forming the window of the step iii), and inserting and adhering the formed window to the through-hole, wherein
   the step iv) of forming the window comprises primarily forming the thickness of the cured window sheet by using a bite having a curvature of 0.3 to 5 mm at a corner portion thereof and performing secondary forming with an embossed mold, and wherein
   the bite is a PCD bite.

10. The method of claim 9, wherein the step iii) comprises steps of: preparing a mold preheated to a first temperature; injecting the composition for window manufacturing into the preheated mold and curing the composition for window manufacturing; and post-curing the cured composition for window manufacturing under a second temperature condition higher than the preheating temperature.

11. A method for manufacturing a semiconductor device, the method comprising steps of:

   1) providing a polishing pad as defined in any one of claims 1 to 8;
   2) polishing the semiconductor substrate while rotating the semiconductor substrate relative to the polishing layer so that a surface to be polished of a semiconductor substrate is in contact with a polishing surface of the polishing layer; and
   3) detecting the thickness of the semiconductor substrate through the window for end-point detection in the polishing pad and detecting the end point of the polishing process.

**Patentansprüche**

1. Ein Polierpad mit einer Polierschicht und einem Fenster zur Endpunktdetektion, **dadurch gekennzeichnet, dass** die Oberflächenrauheit (Ra) der Polierschicht und des Fensters zur Endpunktdetektion eine Änderungsrate der Oberflächenrauheit (SRR) gemäß der folgenden Gleichung 1 von 1,9 bis 2,2 aufweist:

[Gleichung 1]

$$SRR = \frac{dRa1}{dRa2}$$

wobei,

dRa1 die Differenz der Oberflächenrauheit zwischen der Polierschicht und dem Fenster vor dem Polieren ist, und dRa2 die Differenz der Oberflächenrauheit zwischen der Polierschicht und dem Fenster ist, die gemessen wird nach der Zufuhr einer kalzinierten Ceriaschlämme auf die Polierschicht mit 200 mL/min, der Aufrechterhaltung einer Waferbelastung von 41,4 kPa (6,0 psi), dem Polieren eines Oxidfilms mit einer Geschwindigkeit von 150 U/min für 60 Sekunden und dem Polieren von 100 Waferblättern unter den obigen Bedingungen.

2. Das Polierpad nach Anspruch 1, wobei das Fenster zur Endpunktdetektion eine Differenz der Oberflächenrauheit (wSRD) gemäß der folgenden Gleichung 2 von 0,3 bis 1,5 aufweist:

[Gleichung 2]

$$wSRD = |Ra_{wi} - Ra_{wf}|$$

wobei,

$Ra_{wi}$ die Oberflächenrauheit (Ra) des Fensters vor dem Polieren ist, und $Ra_{wf}$ die Oberflächenrauheit (Ra) des Fensters ist, die gemessen wird nach der Zufuhr einer kalzinierten Ceriaschlämme auf die Polierschicht mit 200 mL/min, der Aufrechterhaltung einer Waferbelastung von 41,4 kPa (6,0 psi), dem Polieren eines Oxidfilms mit einer Geschwindigkeit von 150 U/min für 60 Sekunden und dem Polieren von 100 Waferblättern unter den obigen Bedingungen.

3. Das Polierpad nach Anspruch 1 oder 2, wobei die Oberflächenrauheit der Polierschicht eine Differenz der Oberflächenrauheit (pSRD) gemäß der folgenden Gleichung 3 von 1 bis 4 aufweist:

[Gleichung 3]

$$pSRD = |Ra_{pi} - Ra_{pf}|$$

wobei,

$Ra_{pi}$ ie Oberflächenrauheit (Ra) der Polierschicht vor dem Polieren ist, und $Ra_{pf}$ die Oberflächenrauheit (Ra) der Polierschicht ist, die gemessen wird nach der Zufuhr einer kalzinierten Ceriaschlämme auf die Polierschicht mit 200 mL/min, der Aufrechterhaltung einer Waferbelastung von 41,4 kPa (6,0 psi), dem Polieren eines Oxidfilms mit einer Geschwindigkeit von 150 U/min für 60 Sekunden und dem Polieren von 100 Waferblättern unter den obigen Bedingungen.

4. Das Polierpad nach einem der Ansprüche 1 bis 3, wobei die Polierschicht und das Fenster vor dem Polieren eine Differenz der Oberflächenrauheit (dRa1) von 6 bis 7 aufweisen.

5. Das Polierpad nach einem der Ansprüche 1 bis 4, wobei in der Polierschicht und dem Fenster die Oberflächenrauheitswerte der Polierschicht und des Fensters gemessen werden nach der Zufuhr einer kalzinierten Ceriaschlämme auf die Polierschicht mit 200 mL/min, der Aufrechterhaltung einer Waferbelastung von 41,4 kPa (6,0 psi), dem Polieren eines Oxidfilms mit einer Geschwindigkeit von 150 U/min für 60 Sekunden und dem Polieren von 100 Waferblättern unter den obigen Bedingungen, und die gemessene Differenz der Oberflächenrauheit (dRa2) 3 bis 4 beträgt.

6. Das Polierpad nach einem der Ansprüche 1 bis 5, wobei das Fenster ein ausgehärtetes Produkt umfasst, das durch Aushärten einer Fensterzusammensetzung hergestellt wird, die ein urethanbasiertes Prepolymer und ein Härtemittel umfasst.

**7.** Das Polierpad nach Anspruch 6, wobei das urethanbasierte Prepolymer einen nicht umgesetzten NCO-Gehalt von 8 Gew.-% bis 10 Gew.-% aufweist.

**8.** Das Polierpad nach einem der Ansprüche 1 bis 7, wobei die Polierschicht ein ausgehärtetes Produkt enthält, das durch Aushärten einer Polierzusammensetzung hergestellt wird, die ein urethanbasiertes Prepolymer, ein Härtemittel und ein Treibmittel umfasst.

**9.** Ein Verfahren zur Herstellung eines Polierpads wie in irgendeinem der Ansprüche 1 bis 8 definiert, umfassend die Schritte:

i) Bereitstellen einer urethanbasierten Prepolymer-Zusammensetzung;
ii) Bereitstellen einer Zusammensetzung zur Fensterherstellung, die die Prepolymer-Zusammensetzung und ein Härtemittel umfasst;
iii) Herstellen eines Fensters durch Aushärten der Zusammensetzung zur Fensterherstellung; und
iv) Bilden einer Durchgangsöffnung in einer Polierschicht, Bilden des Fensters gemäß Schritt iii) und Einsetzen sowie Anhaften des gebildeten Fensters an die Durchgangsöffnung, wobei
der Schritt iv) des Bildens des Fensters das primäre Bilden der Dicke des ausgehärteten Fensters umfasst, durch Verwendung einer Schneide mit einer Krümmung von 0,3 bis 5 mm an einer Eckpartie, und das sekundäre Bilden mit einer geprägten Form, und wobei
die Schneide eine PCD-Schneide ist.

**10.** Das Verfahren nach Anspruch 9, wobei der Schritt iii) die Schritte umfasst: Bereitstellen einer Form, die auf eine erste Temperatur vorgewärmt ist; Injizieren der Zusammensetzung zur Fensterherstellung in die vorgewärmte Form und Aushärten der Zusammensetzung zur Fensterherstellung; und Nachhärten der ausgehärteten Zusammensetzung zur Fensterherstellung unter einer zweiten Temperaturbedingung, die höher ist als die Vorwärmtemperatur.

**11.** Ein Verfahren zur Herstellung eines Halbleiterbauelements, umfassend die Schritte:

1) Bereitstellen eines Polierpads gemäß einem der Ansprüche 1 bis 8;
2) Polieren des Halbleitersubstrats, während das Halbleitersubstrat relativ zur Polierschicht rotiert, so dass eine zu polierende Oberfläche des Halbleitersubstrats mit einer Polieroberfläche der Polierschicht in Kontakt steht; und
3) Detektieren der Dicke des Halbleitersubstrats durch das Fenster zur Endpunktdetektion im Polierpad und Bestimmen des Endpunkts des Poliervorgangs.

**Revendications**

**1.** Tampon de polissage présentant une couche de polissage et une fenêtre pour une détection de point limite, **caractérisé en ce que** la rugosité de surface (Ra) de la couche de polissage et de la fenêtre pour la détection de point limite présente un taux de rugosité à variation différentielle (SRR) comprise entre 1,9 et 2,2, représenté par l'équation 1 suivante :

[Équation 1]

$$SRR = \frac{dRa1}{dRa2}$$

où

dRa1 est un différentiel de rugosité de surface entre la couche de polissage et la fenêtre avant polissage, et dRa2 est un différentiel de rugosité de surface entre la couche de polissage et la fenêtre mesurée après application à 200 ml/min d'une suspension d'oxyde de cérium calcinée sur la couche de polissage.
maintien d'une charge de tranche de 41,4 kPa (6,0 psi), polissage d'un film d'oxyde à une vitesse de 150 tours par minute pendant 60 secondes, et polissage de 100 feuilles de tranche dans les conditions susmentionnées.

2. Tampon de polissage selon la revendication 1, où la fenêtre pour la détection de point limite présente un différentiel de rugosité de surface (wSRD) compris entre 0,3 et 1,5, représenté par l'équation 2 suivante :

$$[\text{Équation 2}]$$

$$wSRD = |Ra_{wi} - Ra_{wf}|$$

où

$Ra_{wi}$ est une rugosité de surface (Ra) de la fenêtre avant polissage, et
$Ra_{wf}$ est une rugosité de surface (Ra) de la fenêtre mesurée après application à 200 ml/min d'une suspension d'oxyde de cérium calciné sur la couche de polissage,
maintien d'une charge de tranche de 41,4 kPa (6,0 psi), polissage d'un film d'oxyde à une vitesse de 150 tours par minute pendant 60 secondes, et polissage de 100 feuilles de tranche dans les conditions susmentionnées.

3. Tampon de polissage selon la revendication 1 ou la revendication 2, où la rugosité de surface de la couche de polissage présente une valeur différentielle de rugosité de surface (pSRD) comprise entre 1 et 4, représentée par l'équation 3 suivante :

$$[\text{Équation 3}]$$

$$pSRD = |Ra_{pi} - Ra_{pf}| \text{ où,}$$

$Ra_{pi}$ est une rugosité de surface (Ra) de la couche de polissage avant polissage, et
$Ra_{pf}$ est une rugosité de surface (Ra) de la couche de polissage mesurée après application à 200 ml/min d'une suspension d'oxyde de cérium calcinée sur la couche de polissage, maintien d'une charge de tranche de 41,4 kPa (6,0 psi), polissage d'un film d'oxyde à une vitesse de 150 tours par minute pendant 60 secondes, et polissage de 100 feuilles de tranche dans les conditions susmentionnées.

4. Tampon de polissage selon l'une des revendications 1 à 3, où la couche de polissage et la fenêtre présentent un différentiel de rugosité de surface (dRa1) compris entre 6 et 7avant polissage.

5. Tampon de polissage selon l'une des revendications 1 à 4, où dans la couche de polissage et la fenêtre, les valeurs de rugosité de surface de la couche de polissage et de la fenêtre sont mesurées après application à 200 ml/min d'une suspension d'oxyde de cérium calcinée sur la couche de polissage, maintien d'une charge de tranche de 41,4 kPa (6,0 psi), polissage d'un film d'oxyde à une vitesse de 150 tours par minute pendant 60 secondes, et exécution du processus de polissage de 100 feuilles de tranches dans les conditions susmentionnées, et où le différentiel de rugosité de surface mesurée (dRa2) est compris entre 3 et 4.

6. Tampon de polissage selon l'une des revendications 1 à 5, où la fenêtre comprend un produit durci obtenu par durcissement d'une composition de fenêtre comprenant un prépolymère à base d'uréthane et un agent de durcissement.

7. Tampon de polissage selon la revendication 6, où le prépolymère à base d'uréthane présente un pourcentage de NCO inaltéré compris entre 8 % en poids et 10 % en poids.

8. Tampon de polissage selon l'une des revendications 1 à 7, où la couche de polissage contient un produit durci obtenu par durcissement d'une composition de polissage comprenant un prépolymère à base d'uréthane, un agent de durcissement et un agent moussant.

9. Procédé de fabrication d'un tampon de polissage selon l'une des revendications 1 à 8, ledit procédé comprenant les étapes suivantes :

i) préparation d'une composition de prépolymère à base d'uréthane ;
ii) préparation d'un composition pour la fabrication de fenêtre comprenant la composition prépolymère et un agent de durcissement ;
iii) fabrication d'une fenêtre par durcissement de la composition pour la fabrication de fenêtres ; et

iv) formation d'un trou traversant dans une couche de polissage, formant la fenêtre de l'étape iii), et insertion et collage de la fenêtre formée sur le trou traversant, où

l'étape iv) de formation de la fenêtre comprend principalement la formation de l'épaisseur de la feuille de fenêtre durcie au moyen d'une gravure ayant une courbure de 0,3 à 5 mm dans une partie conique de celle-ci et exécution d'une formation secondaire avec un moule en relief, et où

la gravure est une gravure par PCD.

10. Procédé selon la revendication 9, où l'étape iii) comprend les étapes suivantes : préparation d'un moule préchauffé à une première température, injection de la composition pour la fabrication de fenêtre dans le moule préchauffé et durcissement de la composition pour la fabrication de fenêtre ; et post-durcissement de la composition durcie pour la fabrication de fenêtre sous une deuxième condition de température supérieure à la température de préchauffage.

11. Procédé de fabrication d'un dispositif semi-conducteur, ledit procédé comprenant les étapes suivantes :

1) préparation d'un tampon de polissage selon l'une des revendications 1 à 8 ;
2) polissage du substrat semi-conducteur par rotation du substrat semi-conducteur par rapport à la couche de polissage, de manière à mettre une surface à polir d'un substrat semi-conducteur en contact avec une surface de polissage de la couche de polissage ; et
3) détection de l'épaisseur du substrat semi-conducteur par la fenêtre pour la détection de point limite dans le tampon de polissage, et détection du point limite du processus de polissage.

[FIG. 1]

[FIG. 2]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210057725
- JP 2008226911 A
- WO 2019031788 A1